# EUROPÄISCHE PATENTSCHRIFT

(11) **EP 0 400 175 B1**
(45) Veröffentlichungstag und Bekanntmachung des Hinweises auf die Patenterteilung: **28.12.1994**
(21) Anmeldenummer: 89109834.5
(22) Anmeldetag: 31.05.1989
(51) Int. Cl.: H01L 31/02, H01L 31/0203, H01L 33/00

(54) **Oberflächenmontierbares Opto-Bauelement**
Surface-mountable optical element
Elément optique fixable sur une surface

(43) Veröffentlichungstag der Anmeldung: 05.12.1990
(73) Patentinhaber: SIEMENS AKTIENGESELLSCHAFT, 80333 München (DE)
(72) Erfinder: Waitl, Günter, D-8400 Regensburg (DE); Schellhorn, Franz, D-8400 Regensburg (DE)

(56) Entgegenhaltungen:
- EP-A- 0 206 584
- EP-A- 0 230 336
- WO-A-83/00408
- IBM TECHNICAL DISCLOSURE BULLETIN, Band 20, Nr. 10, März 1978, Seite 4090, New York, US; R.W. LISSNER et al.: "Solderless connection method"
- PATENT ABSTRACTS OF JAPAN, Band 6, Nr. 160 (E-126)[1038], 21. August 1982 & JP-A-57 79 681
- PATENT ABSTRACTS OF JAPAN, Band 12, Nr. 498 (E-698)[3345], 26. Dezember 1988 & JP-A-63 208 279

## Beschreibung

Die Erfindung betrifft ein oberflächenmontierbares Opto-Bauelement.

SMD (Surface Mounted Devices) steht für eine neue Aufbautechnik von Flachbaugruppen. Es umfaßt sowohl eine völlig neue Art der Verarbeitung der Bauelemente, nämlich die Oberflächenmontage, als auch eine neue Generation von Bauelementen selbst, die zu der neuen Technik passen müssen.

Die Oberflächenmontage wird die herkömmliche Technik der Einsteckmontage mehr und mehr ablösen. Oberflächenmontage heißt, daß unbedrahtete Bauelemente anstelle von bedrahteten auf die Leiterplatte gebracht werden. So können Bauelemente auf beiden Seiten der Leiterplatte plaziert werden. Mit SMD können weitere Vorteile genutzt werden: Die Flachbaugruppen werden kleiner, die Fertigung wird rationeller, die Zuverlässigkeit wird größer.

SMD-Bauelemente sind dann wirtschaftlicher verwendbar, wenn sie in Bestückautomaten verarbeitet werden. Die Vorteile der Oberflächenmontage sind um so größer, je besser Bauelemente, Leiterplatten-Layout, automatische Bestückung, Löttechnik und Prüfen aufeinander abgestimmt sind.

EP-A-0 206 584 beschreibt ein oberflächenmontierbares Bauelement mit mindestens zwei Oberflächen mit zwei elektrischen Anschlüssen an jeder dieser mindenstens zwei Oberflächen, so daß das Bauelement wahlweise auf jeder dieser zwei Oberflächen auf ein Substrat montierbar ist.

Aus EP-A-0 083 627 ist ein oberflächenmontierbares Opto-Bauelement bekannt. Dieses Bauelement ist nur dazu geeignet, Licht in der Richtung von der Leiterplatte weg zu senden oder zu empfangen.

Der vorliegenden Erfindung liegt die Aufgabe zugrunde, ein oberflächenmontierbares Opto-Bauelement der eingangs genannten Art anzugeben, das flexibel eingesetzt werden kann.

Diese Aufgabe wird durch ein oberflächenmontierbares Opto-Bauelement nach dem Patentanspruch 1 gelöst.

Ausgestaltungen und Vorteile der Erfindung sind in den Unteransprüchen, der Beschreibung und der Zeichnung angegeben.

Ein Bauelement nach der Erfindung kann wahlweise auf einer von mindestens zwei Oberflächen auf ein Substrat montiert werden. Damit ergibt sich die Möglichkeit, daß je nach Art der Montage das Opto-Bauelement nach der Erfindung Licht aus unterschiedlichen Richtungen empfangen oder in unterschiedliche Richtungen senden kann. So kann ein Bauelement nach der Erfindung einmal so auf ein Substrat montiert werden, daß es Licht nur in Richtung senkrecht zum Substrat sendet oder empfängt (top-looker), und kann in einer anderen Montiervariante so auf ein Substrat montiert werden, daß es das Licht parallel zur Oberfläche sendet oder empfängt (side-looker).

Ein Bauelement nach der Erfindung kann in flexibler Weise für eine Reflexlichtschranke verwendet werden. In einem solchen Fall enthält ein solches Bauelement sowohl einen optischen Sender als auch einen optischen Empfänger.

Ein Bauelement nach der Erfindung kann infrarotes oder sichtbares Licht senden und/oder empfangen.

Ein Bauelement nach der Erfindung kann in einer beliebigen Richtung bezüglich der Oberfläche des Substrats, auf welches das Bauelement montiert ist, Licht senden und/oder empfangen.

Bauelemente nach der Erfindung können in einfacher Weise für eine Lichtschranke verwendet werden.

Bauelemente nach der Erfindung können in einfacher Weise für eine Infrarot-Fernbedienung von irgendwelchen Geräten, beispielsweise Video- oder Audio-Geräten, verwendet werden.

Die Erfindung wird im folgenden anhand der Zeichnung näher erläutert.

FIG 1 erläutert eine Herstellungsmöglichkeit eines Bauelements nach der Erfindung.

FIG 2 bis 4 erläutern mögliche Ausführungsformen der Erfindung.

FIG 5 und 6 erläutern mögliche Anwendungen der Erfindung.

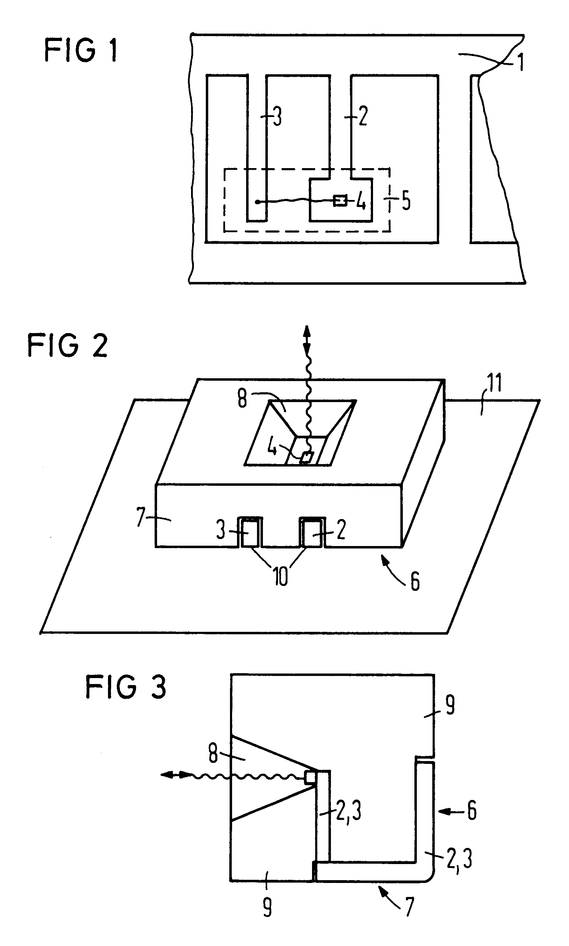

FIG 1 erläutert eine mögliche Herstellungsform eines Bauelements nach der Erfindung. Ein metallischer Träger (leadframe) 1 weist elektrische Anschlüsse 2, 3 des späteren oberflächenmontierbaren Opto-Bauelements auf. Auf den elektrischen Anschluß 2 werden optische Sender- und/oder Empfänger 4 aufgebracht und mit Hilfe einer sogenannten Bond-Draht-Technik mit dem elektrischen Anschluß 3 verbunden. Erst nach Herstellung der Bond-Draht-Verbindung werden der Halbleiterkörper, der Bond-Draht und Teile der Anschlüsse 2, 3 mit Kunststoff, z. B. mit Duroplasten oder mit Thermoplasten, umpreßt oder umgossen. Dieser Kunststoff bildet die Umhüllung 5 bzw. das Gehäuse 5 des oberflächenmontierbaren Opto-Bauelements. Schließlich werden die elektrischen Anschlüsse 2, 3 vom Rest des metallischen Trägers 1 getrennt. Sodann werden die elektrischen Anschlüsse 2, 3, soweit sie aus dem Gehäuse 5 herausragen, so gebogen, daß sie an mindestens zwei Oberflächen 6, 7 des oberflächenmontierbaren Opto-Bauelements vorhanden sind.

FIG 2 bis 4 zeigen mögliche Ausführungsformen eines Bauelements nach der Erfindung. Als optische Sender und/oder Empfänger 4 können Halbleiter-Bauelemente verwendet werden. Als optische Sender und/oder Empfänger können jedoch auch andere Bauelemente verwendet werden. Optische Sender 4 werden vorteilhaft in einem Reflektor 8 angeordnet. Dieser Reflektor 8 kann entweder als Prägung in einem Metallträger 2 oder durch Umhüllung mit einem reflektierenden Kunststoff 5 ausgebildet werden. Eine Kombination aus Prägung im Metallträger 2 und Umhüllung mit einem reflektierenden Kunststoff 5 ist ebenfalls möglich.

Damit ein Bauelement nach der Erfindung beim Löten auf einem Substrat 11, z. B. auf einer Leiterplatte, nicht umkippt, können die elektrischen Anschlüsse 2, 3 in Vertiefungen 10 der Oberflächen 6, 7 angeordnet sein. Das Umkippen des Bauelements beim Löten kann jedoch auch dadurch verhindert werden, daß an den Oberflächen 6, 7 des Bauelements Abstandshalter 9 vorgesehen sind, die aus den Oberflächen 6, 7 herausragen.

Ein oberflächenmontierbares Bauelement nach der Erfindung eignet sich sowohl für ein sogenanntes Reflow-Löten als auch für Schwall-Löten.

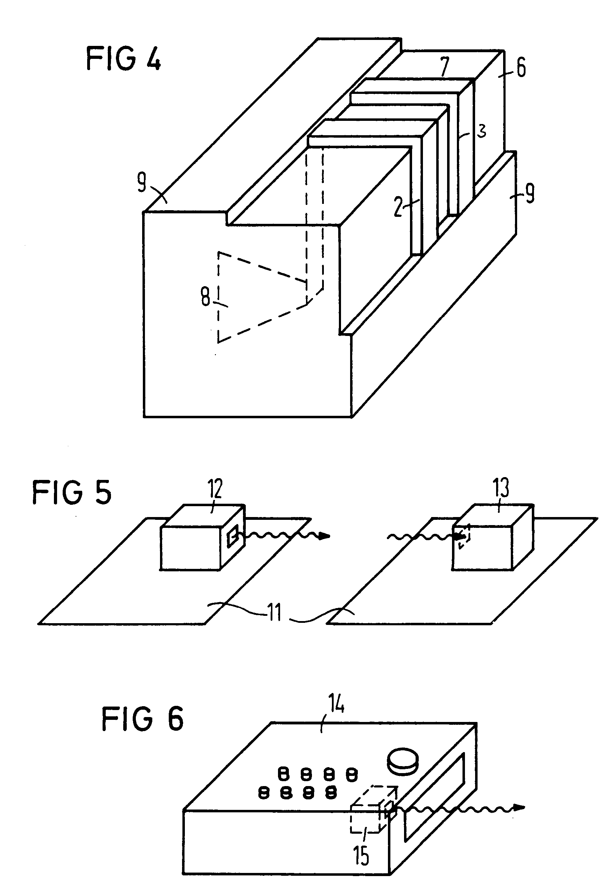

FIG 2 zeigt ein Bauelement nach der Erfindung als Top-Looker. FIG 3 zeigt ein Bauelement nach der Erfindung als Side-Looker. FIG 4 erläutert, wie die elektrischen Anschlüsse 2, 3 aus dem Inneren des Gehäuses 5 herausgeführt werden in Richtung zur Oberfläche 6 des Bauelements hin und sodann einen Teil der Oberfläche 6 bedecken und an der Grenze zwischen den Oberflächen 6, 7 des Bauelements umgebogen sind und schließlich einen Teil der Oberfläche 7 bedecken. Damit ist die Möglichkeit gegeben, das Bauelement sowohl mit der Oberfläche 6 als auch mit der Oberfläche 7 auf einem Substrat 11 zu montieren.

Das Bauelement kann auch mehrere Oberflächen aufweisen, von denen jeweils eine Oberfläche an eine nächste Oberfläche angrenzt, und wobei sich mindestens zwei elektrische Anschlüsse über mehrere Oberflächen hinweg erstrecken.

FIG 5 zeigt eine Lichtschranke mit einem optischen Bauelement als Sender 12 und einem optischen Bauelement als Empfänger 13.

FIG 6 zeigt schematisch ein Gerät 14 zur Fernbedienung von Video- oder Audio-Geräten mit einem Bauelement nach der Erfindung als optischem Sender 15.

Die elektrischen Anschlüsse des Opto-Bauelements können auch so gestaltet sein, daß diese elektrischen Anschlüsse an mindestens zwei Oberflächen aus der Umhüllung des Opto-Bauelements austreten. Beispielsweise können die elektrischen Anschlüsse 2, 3 in FIG 1 so gestaltet sein, daß nach Abtrennung der elektrischen Anschlüsse 2, 3 vom Rest des metallischen Trägers 1 auf zwei verschiedenen Oberflächen des Gehäuses zwei Paare von elektrischen Anschlüssen hervorstehen. Diese beiden Paare von elektrischen Anschlüssen können so gestaltet werden, daß mindestens zwei verschiedene Oberflächen des Opto-Bauelements mit einem Substrat verbindbar sind. Vorzugsweise grenzen solche Oberflächen sukzessive aneinander.

Ein Opto-Bauelement nach der Erfindung wird vorzugsweise für elektronische Halbleiter-Bauelemente verwendet.

## Patentansprüche

1. Oberflächenmontierbares Opto-Bauelement mit mindestens einem Sender und/oder Empfänger (4) in mindestens einem ein optisches Fenster aufweisenden Gehäuse (5), mit mindestens zwei Oberflächen (6, 7), mit mindestens zwei elektrischen Anschlüssen (2, 3) an jeder dieser mindestens zwei Oberflächen (6, 7), so daß das Opto-Bauelement wahlweise auf jeder dieser zwei Oberflächen (6, 7) auf ein Substrat (11) montierbar ist.

2. Bauelement nach Anspruch 1,
**dadurch gekennzeichnet**, daß zwei Oberflächen (6, 7) miteinander einen Winkel von 90° einschließen.

3. Verwendung eines Bauelements nach Anspruch 1 oder 2 als Top-Looker.

4. Verwendung eines Bauelements nach Anspruch 1 oder 2 als Side-Looker.

5. Verwendung eines Bauelements nach Anspruch 1 oder 2 für eine Lichtschranke.

6. Verwendung eines Bauelements nach Anspruch 1 oder 2 für eine optoelektronische Fernbedienung eines Video- oder Audio-Geräts.

## Claims

1. Surface-mountable optical element having at least one transmitter and/or receiver (4) in at least one housing (5) exhibiting an optical window, having at least two surfaces (6, 7), having at least two electrical terminals (2, 3) at each one of these at least two surfaces (6, 7), so that the optical element is mountable onto a substrate (11) optionally at each one of these two surfaces (6, 7).

2. Element according to Claim 1, characterized in that two surfaces (6, 7) include an angle of 90° with one another.

3. Use of an element according to Claim 1 or 2 as top looker.

4. Use of an element according to Claim 1 or 2 as side looker.

5. Use of an element according to Claim 1 or 2 for a light barrier.

6. Use of an element according to Claim 1 or 2 for an optoelectronic remote control of a video system or audio system.

## Revendications

1. Composant optique pouvant être monté en surface, comportant au moins un émetteur et/ou un récepteur (4) dans au moins un boîtier (5) ayant une fenêtre optique et comportant au moins deux surfaces (6, 7), au moins deux bornes électriques (2, 3) situées sur chacune de ces au moins deux surfaces (6, 7), de sorte que le composant optique peut être monté au choix sur chacune de ces deux surfaces (6, 7) sur un substrat (11).

2. Composant suivant la revendication 1, caractérisé par le fait que deux surfaces (6, 7) font entre elles un angle de 90°.

3. Utilisation d'un composant suivant la revendication 1 ou 2 en tant que Top-Looker.

4. Utilisation d'un composant suivant la revendication 1 ou 2 en tant que Side-Looker.

5. Utilisation d'un composant suivant la revendication 1 ou 2 pour un barrage photoélectrique.

6. Utilisation d'un composant suivant la revendication 1 ou 2 pour une commande optoélectronique à distance d'un appareil vidéo ou d'un appareil audio.
